# EUROPEAN PATENT APPLICATION

(11) **EP 4 266 363 A1**
(43) Date of publication of application: **25.10.2023**
(21) Application number: 22305596.3
(22) Date of filing: 21.04.2022
(51) Int. Cl.: H01L 23/44, H01L 23/473, H01L 23/498, H01L 23/46, H01L 23/467

(54) **IMPROVED POWER COMPONENT FOR ELECTRIC OR HYBRID AIRCRAFT**

(71) Applicant: Airbus SAS, 31700 Blagnac (FR)
(72) Inventor: GALLA, Gowtham, 31700 BLAGNAC (FR); SURAPANENI, Ravi Kiran, 31700 BLAGNAC (FR); YBANEZ, Ludovic, 31700 BLAGNAC (FR); KAPAUN, Florian, 82024 TAUFKIRCHEN (DE); STEINER, Gerhard, 82024 TAUFKIRCHEN (DE)
(74) Representative: Cabinet Le Guen Maillet

(57) **Abstract**

The invention relates to an electronic component (100) comprising a substrate (102) to which are connected a plurality of connection pins (104, 106) and on one face of which is affixed an electronic die fixing layer (110), and at least one electronic die (112) assembled on said electronic die fixing layer (110), said electronic component (100) further comprising a first heat exchanger (120) and a layer of thermally conductive and electrically insulating material (122) arranged in contact with said substrate (102), and wherein
- said first heat exchanger (120) is configured to receive a circulating cryogenic fluid, and,
- said at least one electronic die (112), said electronic die fixing layer (110), said substrate (102) and said layer of thermally conductive and electrically insulating material (122) as well as one end of each of said connection pins (104, 106) are enveloped in a volume of electrically insulating material at cryogenic temperature (130).

It is thus advantageously possible to obtain an increased ratio between the weight of an aircraft and the electrical power available on board for the aircraft systems.

## Description

### TECHNICAL FIELD

The present invention relates to electronic components of the integrated circuit type. The invention relates more particularly to power electronic components and in particular those used in on board systems of an aircraft.

### RELATED ART

Liquid hydrogen is a cryogenic fluid that can be used as an energy source for electricity generation. Thus, for example, it is possible to use a hydrogen fuel cell to power all the flight control and communication systems of an aircraft, as well as the on-board lighting and the power supply of various accessory devices used in the aircraft. Liquid hydrogen can also be used as an energy source for the propulsion of an aircraft, by powering a fuel cell or by direct combustion, which has the advantage of only releasing water into the atmosphere. The use of hydrogen requires distribution systems between one or more production or storage tanks and consuming devices. Thus, pipes are conventionally used to convey liquid hydrogen between a storage tank and a liquid hydrogen consuming device such as, for example, a hydrogen fuel cell.

It is known that there is a need to massively reduce the production of carbon emissions, to safeguard the environment, and electric or hybrid propulsion is showing promise for this. But the conventional systems on board of an aircraft are such that the weight/electrical power ratio is not satisfactory as they are and there is therefore a need to obtain electrical systems making it possible to provide power in relation to their weight to satisfy all the constraints.

It is therefore necessary to optimize the weight/electrical power ratio of all the elements of an aircraft propulsion system, and in particular the power components through which strong currents pass.

The situation can be improved.

### SUMMARY OF THE INVENTION

The aim of the invention is to obtain an increased ratio between the weight of an aircraft and the electrical power available on board for the aircraft systems for the purpose of reducing the energy required to perform an aircraft flight.

To this end, it is proposed an electronic component comprising an electrically conducting substrate having a first face and a second face opposite to the first face, a plurality of connection pins having a first end connected to the electrically conducting substrate and a second end opposed to the first end, and an electronic die fixing layer affixed to the first face of the electrically conducting substrate, and at least one electronic die assembled on said electronic die fixing layer, said electronic component further comprising a first heat exchanger and a layer of thermally conductive and electrically insulating material arranged in contact with said electrically conducting substrate, and said electronic component being characterized in that:
- said first heat exchanger is configured to receive a circulating cryogenic fluid, and,
- said at least one electronic die, said electronic die fixing layer, said electrically conducting substrate and said layer of thermally conductive and electrically insulating material as well as the first end of said connection pins are enveloped in a volume of electrically insulating material at cryogenic temperature.

This advantageously makes it possible to reduce the losses due to Joule effect dependent on the resistivity, which resistivity depends on the temperature.

The electrical component according to the invention may also include the following characteristics, considered alone or in combination:
- All or part of said first heat exchanger is enveloped in said volume of electrically insulating material at cryogenic temperature.
- The layer of thermally conductive and electrically insulating material is arranged between the electrically conducting substrate and the first heat exchanger.
- Said first heat exchanger is formed inside the electrically conducting substrate.
- The first end of at least one connection pin passes through a second heat exchanger configured to receive a circulating cryogenic fluid.
- Said first heat exchanger and said second heat exchanger form a same heat exchanger.
- Said electrically insulating material at cryogenic temperature is a resin.
- Said cryogenic fluid for the circulation of which the first or the second exchanger is configured is selected from among: liquid or gaseous hydrogen, liquid or gaseous nitrogen, liquid or gaseous neon, liquid or gaseous helium.

Another object of the invention is an electronic system comprising two superconducting elements and an electronic component as described above connecting said two superconducting elements.

The invention also relates to an aircraft comprising an electronic component as previously described or to an electronic system as described above.

### BRIEF DESCRIPTION OF THE DRAWINGS

The characteristics of the invention mentioned above, as well as others, will appear more clearly on reading the following description of at least one embodiment, said description being made in relation to the attached drawings, among which:
[Fig. 1] schematically illustrates an electronic power component according to an embodiment;
[Fig. 2] schematically illustrates the electronic power component already shown in Fig. 1 according to a second embodiment;
[Fig. 3] schematically illustrates the electronic power component already shown in Fig. 1 according to a third embodiment; and
[Fig. 4] illustrates an aircraft comprising an electronic power component as already described in Fig. 1, Fig. 2, or Fig. 3.

### DETAILED DESCRIPTION OF AT LEAST ONE EMBODIMENT

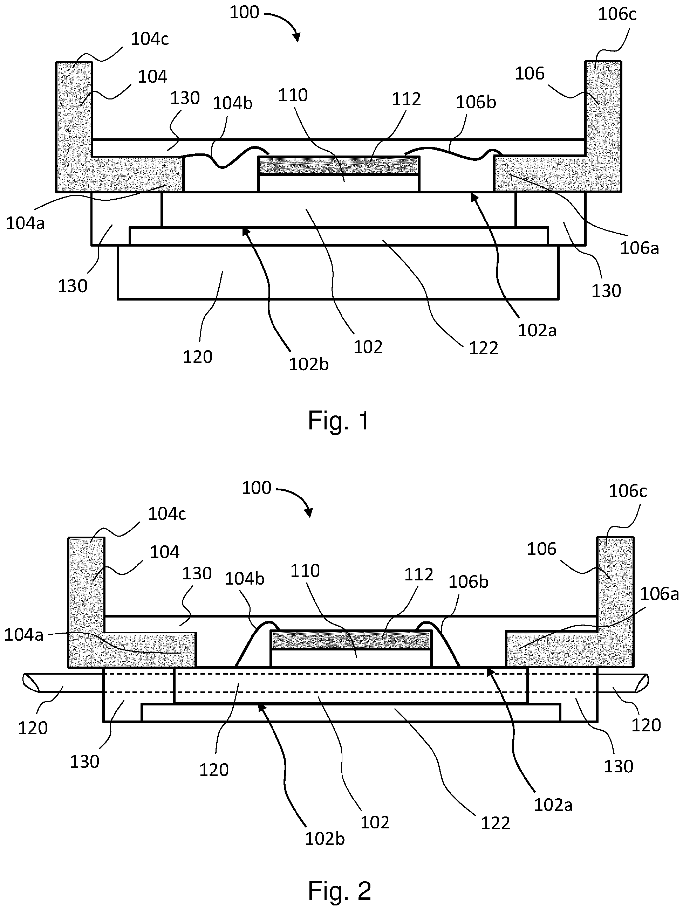

**Fig. 1** schematically illustrates an architecture of an electronic power component 100 according to a first embodiment. The electronic power component 100 is an integrated circuit configured to operate a predefined function in an electronic system and to be traversed by high currents or to deliver high currents, such as to generate losses by Joule effect. The electronic component 100 comprises an electrically conducting substrate 102. The substrate 102 carries on its upper face 102a a fixing layer 110 provided for fixing an integrated die 112 (electronic core) on the substrate 102. The electronic component 100 further comprises connection pins 104 and 106 coming into contact with the electrically conductive substrate 102 at their first end 104a, 106a. The second end 104c, 106c of the connection pins 104, 106 being intended to be connected to elements of the superconducting type (not shown in the figures). Connection links called "bonding" 104b and 106b make it possible to respectively connect the connection pins 104 and 106 to the integrated die 112. The lower face 102b of the substrate 102 carries a layer 122 of a thermally conductive and electrically insulating material. The layer 122 of thermally conductive and electrically insulating material is in contact with a first heat exchanger 120 included in the electronic component 100. Cleverly, the first heat exchanger 120 is configured to make it possible to make circular therein a cryogenic fluid useful for cooling the electronic component 100. The cryogenic fluid has, for example, a temperature less than -253°C. For example, the first heat exchanger 120 comprises one or more pipes of reduced size for the circulation of the cryogenic fluid. The circulation of the cryogenic fluid in the first heat exchanger 120 is ensured by means of an external circulator, not shown in Fig. 1. According to one embodiment of the invention, the cryogenic fluid is liquid hydrogen (LH2) or more precisely dihydrogen in the liquid state. According to variants, the cryogenic fluid used to operate a cooling of the electronic component 100, thanks to the first heat exchanger 120, can be liquid or gaseous hydrogen, liquid or gaseous nitrogen, liquid or gaseous neon or even liquid or gaseous helium.

Thus, the temperature of the component is very low, and the resistivity of the conductive materials is substantially reduced, consequently limiting the losses by Joule effect, which makes it possible to improve the yield and therefore the ratio between the weight of the electronic component 100 is the electrical power it can withstand or deliver. Cleverly again, the substrate 102, the electronic die 112, the electronic die fixing layer 110 and the layer of thermally conductive and electrically insulating material 122, as well as at least the ends 104a, 106a of the connection pins 104 and 106 in contact with the substrate 102 are enveloped in a volume of material 130 electrically insulating at cryogenic temperature (and not freezing at cryogenic temperature). According to an exemplary embodiment, the volume of material 130 used is made of a hard insulating resin. In Fig. 1, the first heat exchanger 120 is not enveloped in the volume of material 130 electrically insulating at cryogenic temperature.

Thus, it is advantageously possible to use the electronic component 100 at cryogenic temperature to limit heat dissipation.

**Fig. 2** illustrates a second embodiment of the electronic component 100. According to this second embodiment, the substrate 102 and the first heat exchanger 120 together form only one and the same element. In other words, the substrate 102 itself comprises pipes of reduced dimensions configured to allow therein a circulation of cryogenic fluid aimed at cooling the electronic component 100. Hence, the first heat exchanger 120 is arranged inside the substrate 102, between the upper and lower faces 102a, 102b of the substrate 102. Thus, the substrate 102 performs a substrate function and a cryogenic cooler element function in the electronic component 100.

In Fig. 2, the connection links 104b and 106b make it possible to connect the integrated die 112 to the connection pins 104 and 106, via the electrically conducting substrate 102. More precisely, each connection link 104b, 106b is connected to the electrically conducting substrate 102, and the electrically conducting substrate 102 is in electrical contact with the connection pins 104 and 106.

In Fig. 2, the substrate 102, the first heat exchanger 120, the electronic die 112, the electronic die fixing layer 110 and the layer of thermally conductive and electrically insulating material 122, as well as at least the ends 104a, 106a of the connection pins 104 and 106 in contact with the substrate 102 are enveloped in a volume of material 130 electrically insulating at cryogenic temperature (and not freezing at cryogenic temperature).

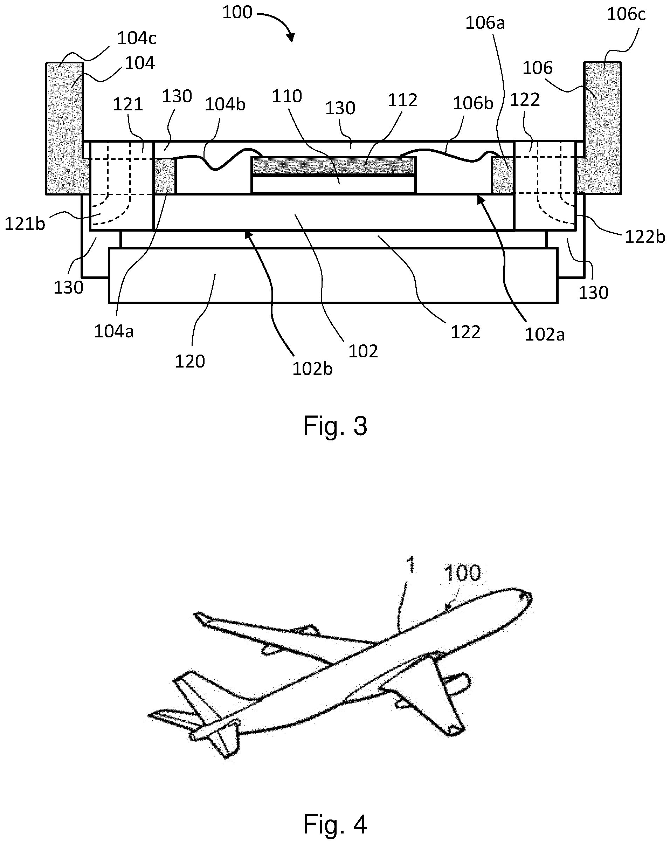

**Fig. 3** illustrates a third embodiment of the electronic component 100. According to this third embodiment, the connection pins 104 and 106 pass through, at their ends 104a, 106a which meets the substrate 102, or not far from them, second heat exchangers 121 and 122 configured to allow a cryogenic fluid to circulate therein and thus provide a thermal insulation barrier around the connection pins 104 and 106. The second heat exchanger 121 is arranged around the connection pin 104 and the second heat exchanger 122 is arranged around the connection pin 106. According to an embodiment, the second heat exchanger 121 comprises a small pipe 121b for cryogenic fluid circulation and the second heat exchanger 122 comprises a small pipe 122b for cryogenic fluid circulation. Here again, the circulation of the cryogenic fluid used is ensured by an external circulator not shown in the figure (a pump, for example).

This advantageously makes it possible to connect conducting elements of the superconducting type to the connection pins 104 and 106 of the electronic component 100, and to avoid transmitting heat to these superconducting elements, which could be detrimental to the expected operation.

According to one embodiment, the second heat exchangers 121 and 122 are extensions (or terminations) of the first heat exchanger 120. That is to say that the first heat exchanger 120 and the second heat exchangers 121 and 122 together form a single and same heat exchanger intended to cool the electronic component 100 and to prevent at the same time heat transfer to superconducting elements connected to the electronic component 100. Advantageously, it is thus possible to combine the use of an electronic component such as the electronic component 100 with the use of electrically conducting elements of the superconducting type.

Advantageously, all or part of the first heat exchanger 120 is enveloped in said volume 130 of electrically insulating material at cryogenic temperature. For instance, on Fig.3, only a part of the first heat exchanger 120 is enveloped in the volume of material 130 electrically insulating at cryogenic temperature.

**Fig. 4** illustrates an aircraft which comprises at least one electronic component such as the electronic component 100, allowing to improve the overall yield of the electrical system of the airplane, or any electronic system comprising such an electronic component.

## Claims

1. Electronic component (100) comprising an electrically conducting substrate (102) having a first face (102a) and a second face (102b) opposite to the first face (102a), a plurality of connection pins (104, 106) having a first end (104a, 106a) connected to the electrically conducting substrate (102) and a second end (104c, 106c) opposed to the first end (104a, 106a), and an electronic die fixing layer (110) affixed to the first face (102a) of the electrically conducting substrate (102), and at least one electronic die (112) assembled on said electronic die fixing layer (110), said electronic component (100) further comprising a first heat exchanger (120) and a layer of thermally conductive and electrically insulating material (122) arranged in contact with said electrically conducting substrate (102), and said electronic component (100) being **characterized in that**:
- said first heat exchanger (120) is configured to receive a circulating cryogenic fluid, and,
- said at least one electronic die (112), said electronic die fixing layer (110), said electrically conducting substrate (102) and said layer of thermally conductive and electrically insulating material (122) as well as the first end (104a, 106a) of said connection pins (104, 106) are enveloped in a volume of electrically insulating material at cryogenic temperature (130).

2. Electronic component (100) according to claim 1, wherein all or part of said first heat exchanger (120) is enveloped in said volume of electrically insulating material at cryogenic temperature (130).

3. Electronic component (100) according to claim 1 or 2, wherein the layer of thermally conductive and electrically insulating material (122) is arranged between the electrically conducting substrate (102) and the first heat exchanger (120).

4. Electronic component (100) according to claim 2, wherein said first heat exchanger (120) is formed inside the electrically conducting substrate (102).

5. Electronic component (100) according to one of claims 1 to 4, wherein the first end (104a, 106a) of at least one connection pin (104, 106) passes through a second heat exchanger (121) configured to receive a circulating cryogenic fluid.

6. Electronic component (100) according to claim 5, wherein said first heat exchanger (120) and said second heat exchanger (121) form a same heat exchanger (120, 121).

7. Electronic component (100) according to one of claims 1 to 6, wherein said electrically insulating material at cryogenic temperature (130) is a resin.

8. Electronic component (100) according to one of claims 1 to 7, wherein said cryogenic fluid is selected among: liquid hydrogen, gaseous hydrogen, liquid nitrogen, gaseous nitrogen, liquid neon, gaseous neon, gaseous helium, liquid helium.

9. Electronic system comprising two superconducting elements and an electronic component according to one of claims 1 to 8 connecting said two superconducting elements.

10. Aircraft comprising an electronic component according to anyone of claims 1 to 8 or an electronic system according to claim 9.
